# EUROPÄISCHE PATENTSCHRIFT

(11) **EP 2 338 581 B1**
(45) Veröffentlichungstag und Bekanntmachung des Hinweises auf die Patenterteilung: **25.12.2013**
(21) Anmeldenummer: 10190903.4
(22) Anmeldetag: 11.11.2010
(51) Int. Cl.: F04D 25/08, F04D 29/52, F04D 29/64, B01D 46/00, H02B 1/56, H05K 7/20, F04D 29/70

(54) **Lüftereinheit für Filterlüfter**
Ventilation unit for filter ventilator
Unité de ventilateur pour ventilateur à filtre

(30) Priorität: 22.12.2009 DE 202009017511 U
(43) Veröffentlichungstag der Anmeldung: 29.06.2011
(73) Patentinhaber: ebm-papst Mulfingen GmbH & Co. KG, 74673 Mulfingen (DE)
(72) Erfinder: Heli, Thomas, Dipl.-Ing., 74595, Langenburg (DE); Günther, Jörg, Dipl.-Design., 74677 Dörzbach (DE); Hofmann, Walter, Dipl.-Ing., 74673 Mulfingen (DE)
(74) Vertreter: Patentanwälte Dr. Solf & Zapf

(56) Entgegenhaltungen:
- EP-A2- 0 352 113
- EP-A2- 1 156 224
- EP-A2- 1 930 601
- EP-A2- 1 967 743
- WO-A1-2008/075872

## Beschreibung

Die Erfindung betrifft eine Lüftereinheit, insbesondere zur Befestigung an einem Filterrahmen eines Filterlüfters, bestehend aus einem Gehäuse mit einem zylinderförmigen Gehäuserand, einer Einlassöffnung, einer Ausströmöffnung und mindestens einem Schutzgitter, welches eine der beiden Öffnungen abdeckt, und einem, in dem Gehäuse durch eine Motoraufnahme befestigten Lüfter, der die Luft zumindest in axialer Richtung fördert.

Derartige Lüftereinheiten werden als Teil eines Filterlüfters für industrielle Anlagen wie z.B. Schaltschränke verwendet. Dabei können die Lüftereinheiten sowohl als blasende Lüftereinheit als auch als saugende Lüftereinheit ausgebildet sein. Bekannte Lüftereinheiten für Filterlüfter weisen in der Regel ein Axiallüfterrad als Strömungsantrieb der Lüftereinheit auf und werden mit dem Filterrahmen des Filterlüfters über einen Befestigungsflansch des Gehäuses der Lüftungseinheit verschraubt. Als Schutz der Lüftereinheit wird auf das Gehäuse der Lüftereinheit ein Schutzgitter verschraubt. Derartige Lüftereinheiten haben den Nachteil, eine hohe Bauhöhe und eine niedrige Effizienz aufzuweisen und sind aufwändig herzustellen. Außerdem müssen sie durch mehrere Arbeitsschritte mit Werkzeugen an dem Filterrahmen montiert werden, und eine Änderung der Förderrichtung ist nur durch eine aufwändige Montage möglich. Während der Wartung des Filterlüfters müssen sowohl die Lüftereinheit als auch das Schutzgitter demontiert und danach wieder montiert werden.

Aus der EP 1 930 601 A2 ist eine Lüftereinheit bekannt, bei dem das Gehäuse schneckenhausförmig ausgebildet ist. In dem Gehäuse ist ein Radiallüfterrad eingebaut, welches von beiden axialen Richtungen des Lüfters durch zwei Einlassöffnungen Luft ansaugt und die Luft senkrecht zur Lüfterachse radial durch eine Ausströmöffnung ausstößt. Dabei ist in einer Einlassöffnung eine Motoraufnahme mittig angeordnet und über in der Einlassöffnung radial verlaufende Streben mit einem der Gehäuseteile verbunden. Die Motoraufnahme dient zur Befestigung des Motors. Das Gehäuse ist senkrecht zur Lüfterachse zweigetellt, wobei jedes Gehäuseteil jeweils eine Einlassöffnung beinhaltet und eine Hälfte der Ausströmöffnung bildet. Beide Gehäuseteile sind über eine Schwenkachse schwenkbar gelagert und miteinander verbunden, so dass sich das Gehäuse teilweise aufklappen lässt. Die Lüftereinheit weist im Bereich der Ausströmöffnung einen Stutzen mit Befestigungsmitteln auf, mit der die Lüftereinheit an dem zu lüftenden Gegenstand befestigt wird. Derartige Lüftereinheiten haben den Nachteil, dass der Schwenkmechanismus aufwändig herzustellen ist und der Öffnungswinkel des Gehäuses nur klein ist, so dass der Lüfter und der Motor in dem Gehäuse nur beschränkt zugänglich sind. Zudem haben die Einlassöffnungen keinen oder nur einen unzureichenden Schutz. Des Weiteren kann die Förderrichtung der Lüftereinheit nicht geändert werden.

Aus der EP 1 156 224 A2 ist eine Ausführungsform einer Lüftereinheit mit einem schneckenhausförmigen Gehäuse bekannt, in dem ein Radiallüfterrad eingebaut ist. Bei dieser Lüftereinheit sind beide Einlassöffnungen mit einem zusätzlich durch Befestigungsmittel an dem Gehäuse angebrachten Schutzgitter versehen. Das Gehäuse ist in diesem Fall parallel zur Lüfterachse zweigeteilt, wobei die beiden Gehäuseteile jeweils einen Flansch aufweisen und mittels Befestigungsmitteln in dem Flansch miteinander verbunden werden. Diese Lüftereinheit hat den Nachteil, dass zur Wartung der Lüftereinheit zunächst die Schutzgitter demontiert werden müssen, um danach die Befestigungsmittel der Gehäuseteile mit einem Werkzeug zu lösen, so dass das Lüfterrad und der Motor zugänglich werden. Auch die Herstellung ist durch die zusätzliche Montage der Schutzgitter aufwändig. Zudem kann auch bei dieser Lüftereinheit die Förderrichtung nicht geändert werden.

In der WO 2008/075872 A1 ist eine Ausführungsform einer Lüftereinheit beschrieben, die ein senkrecht zur Lüfterachse zweigeteiltes Gehäuse aufweist, in dem ein Axiallüfterrad eingebaut ist. Dabei weist das eine Gehäuseteil die Einlassöffnung und das andere Gehäuseteil die Ausströmöffnung auf. Der Motor des Axiallüfterrades ist über separate Haltestangen an einem Gehäuseteil befestigt. Die Einlassöffnung und die Ausströmöffnung sind durch separate Schutzgitter, die von außen an den Gehäuseteilen befestigt sind, abgedeckt. An einem Gehäuseteil sind am Rand Gelenke ausgebildet, an denen Standbeine befestigt sind. Die Lüftereinheit kann mittels der Gelenke zwischen zwei Standbeinen gedreht werden, so dass die Förderrichtung verändert werden kann.

Der Erfindung liegt die Aufgabe zugrunde, eine Lösung zu schaffen, die es ermöglicht, eine kompaktere Lüftereinheit auf einfachere Weise und kostengünstiger herzustellen, die eine hohe Effizienz zur Verfügung stellt und besonders einfach sowohl als saugende als auch als blasende Lüftereinheit in dem Filterlüfter eingebaut und zur Wartung des Pilterlüfters besonders einfach demontiert werden kann.

Bei einer Lüftereinheit der eingangs beschriebenen Art wird die Aufgabe erfingdungsgemäß durch die Merkmale des Anspruchs 1 gelöst. Das Gehäuse ist senkrecht zur Achse des Lüfterrades im Bereich des Gehäuserandes in mindestens zwei lösbar miteinander verbundene Gehäuseteile, das Motorhalterungsteil und das Lufteinlassteil, geteilt ist, wobei sowohl das Motorhalterungsteil als auch das Lufteinlassteil jeweils einstückig eine Schutzgitterstruktur bilden. Dabei weist die Schutzgitterstruktur des Motorhalterungsteils eine Motoraufnahme mit Befestigungsmitteln zur Befestigung des Lüfters auf. Die Teilung des Gehäuses in zwei Hälften zusammen mit der einstückigen Ausgestaltung ermöglicht einen besonders einfachen Einbau des Lüfters in das Gehäuse der Lüftereinheit. Außerdem sind dadurch das Gehäuse und die Lüftereinheit besonders einfach und kostengünstig herzustellen und die Bauform der Lüftereinheit ist besonders kompakt zu gestalten.

Erfindungsgemäß ist an dem Umfang des Motorhalterungsteils und an dem Umfang des Lufteinlassteils jeweils mindestens ein Befestigungsflansch mit Befestigungsmitteln ausgebildet. Vorzugsweise bestehen dabei die Befestigungsmittel der Lüftereinheit aus mehreren schlüssellochförmigen Bajonett-Öffnungen, und die Befestigungsmittel des Filterrahmens aus jeweils dazu passenden pilzförmigen Befestigungsknöpfen, wobei die Befestigungsmittel der Lüftereinheit und des Filterrahmens einen Bajonettverschluss bilden. Zusätzlich weisen die Befestigungsmittel der Befestigungsflansche ein Rastloch mit einem in dem Rastloch über einen radialen Steg angebrachten Entriegelungsknopf, und die Befestigungsmittel des Filterrahmens mindestens einen auf einem der Befestigungsansätze des Filterrahmens aufgebrachten Rasthaken auf. Dies hat den Vorteil, dass die Montage der Lüftereinheit werkzeuglos erfolgen kann und die Lüftereinheit besonders einfach und sicher auf dem Filterrahmen montiert und demontiert werden kann.

Des Weiteren sind bei einer Ausführungsform der Erfindung das Lüfterrad des Lüfters als Diagonallüfterrad ausgebildet und im radial äußeren Bereich einer oder beider Schutzgitterstruktur(en) nach außen gerichtete, schräg zur Achse des Lüfters geneigte Haltestreben ausgebildet, so dass eine oder beide Schutzgitterstruktur(en) tellerförmig ausgebildet sind und der Tellerboden nach außen aus der jeweiligen durch die Schutzgitterstruktur abgedeckten Öffnung des Gehäuses herausragt. Dabei ist es von besonderem Vorteil, wenn der Durchmesser der Ausströmöffnung dem Durchmesser des Gehäuserandansatzes des Motorhalterungsteils entspricht, und der Durchmesser der Einlassöffnung kleiner als der Durchmesser des Gehäuserandansatzes des Lufteinlassteils ist. Diese Aufführungsform hat den Vorteil, dass in Abströmrichtung und/oder in Ansaugrichtung des Lüfters dem Luftstrom ein minimaler Widerstand geboten wird und die Luftströmung, und die Effizienz der Lüftereinheit verbessert werden.

In einer weiteren Ausführungsform der Erfindung weist das Motorhalterungsteil und das Lufteinlassteil jeweils seitlich am Umfang des jeweiligen Gehäuserandansatzes oder alternativ an dem jeweiligen Befestigungsflansch ein offenes Steckergehäuseteil zur Aufnahme eines Steckeranschlusses der Lüftereinheit auf, wobei innerhalb des aus den Steckergehäuseteilen gebildeten Steckergehäuses ein Steckeraufnahmeteil angeordnet ist. Dies ermöglicht eine einfache Verbindung der elektrischen Lüfteranschlussverbindung mit der Steckerverbindung der Lüftereinheit und optionalen zusätzlichen Kondensatoren und ermöglicht eine einfache Montage der Lüftereinheit. Dabei ist es besonders vorteilhaft, wenn sowohl das Motorhalterungsteil als auch das Lufteinlassteil vier im Winkel von 90° über den Umfang gleichmäßig verteilte Befestigungsflansche aufweisen, so dass die Lüftereinheit in vier verschiedenen Positionen variabel an dem Filterrahmen montiert werden kann, und die Position des Steckergehäuses an die Raumverhältnisse des Filterlüfters oder der Umgebung angepasst werden kann.

Die vorgenannten sowie beanspruchten und in den Ausführungsbeispielen beschriebenen erfindungsgemäß zu verwendenden Bauteile unterliegen in ihrer Größe, Form, Gestaltung, Materialauswahl und technischen Konzeptionen keinen besonderen Ausnahmebedingungen, so dass die in dem Anwendungsgebiet bekannten Auswahlkriterien uneingeschränkt Anwendung finden können.

Weitere Einzelheiten, Merkmale und vorteilhafte Weiterbildungen der Erfindung ergeben sich aus dem im Folgenden beschriebenen und in den Zeichnungen dargestellten Ausführungsbeispielen sowie aus den Unteransprüchen. Es zeigen:
- Fig. 1: eine Explosionszeichnung einer erfindungsgemäßen Lüftereinheit mit Sicht auf die Einlassöffnung,
- Fig. 2: eine Explosionszeichnung einer erfindungsgemäßen Lüftereinheit mit Sicht auf die Ausströmöffnung;
- Fig. 3: eine zusammengebaute erfindungsgemäße Lüftereinheit mit Sicht auf die Einlassöffnung,
- Fig. 4: eine zusammengebaute erfindungsgemäße Lüftereinheit mit Sicht auf die Ausströmöffnung;
- Fig. 5: eine Explosionszeichnung einer erfindungsgemäßen Lüftereinheit mit Filterrahmen mit Sicht auf die Einlassöffnung.

Gleiche Merkmale in den verschiedenen Figuren sind mit denselben Bezugszeichen versehen.

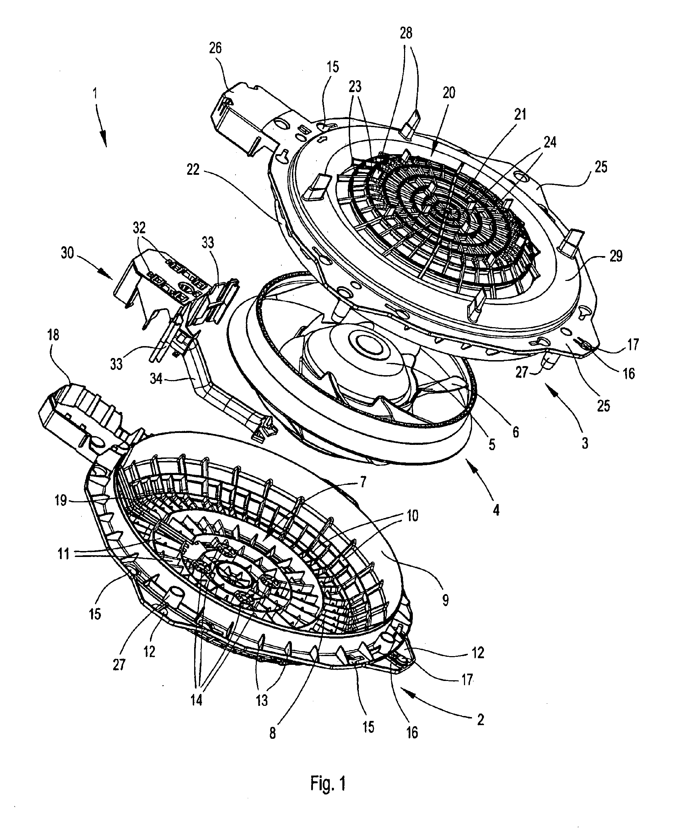

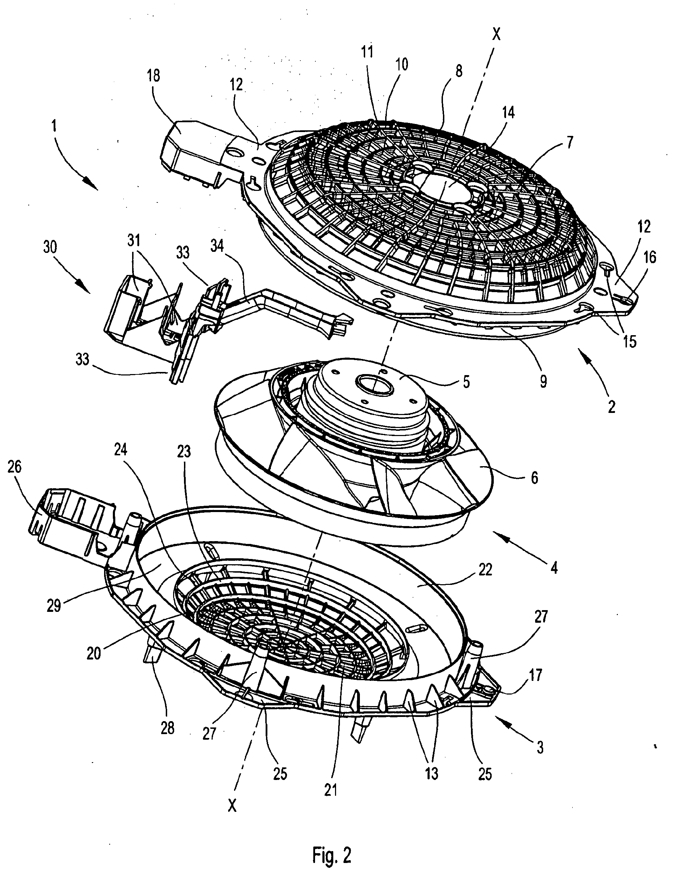

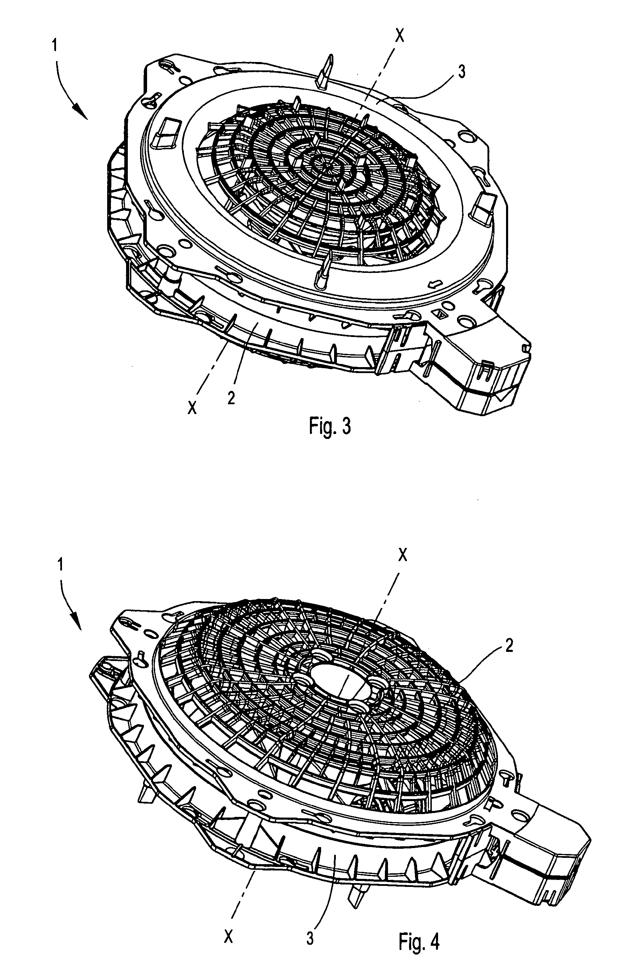

In Fig. 1, Fig. 2 , Fig. 3 und Fig. 4 ist eine Ausführungsform einer erfindungsgemäßen Lüftereinheit 1 dargestellt. Die Lüftereinheit 1 weist ein zweiteiliges Gehäuse auf, welches aus einem Motorhalterungsteil 2 und einem Lufteinlassteil 3 besteht. Außerdem ist in dem Gehäuse ein Lüfter 4 montiert. Der Lüfter 4 besteht aus einem vorzugsweise elektronisch gesteuerten Elektromotor 5, insbesondere einem Außenläufermotor, mit einem auf dem Rotor des Elektromotors 5 befestigten Diagonallüfterrad oder Axiallüfterrad.

Das Motorhalterungsteil 2 ist vorzugsweise einteilig ausgebildet und besteht vorzugsweise aus Kunststoff. Es weist eine Ausströmöffnung 7 auf, die von einer tellerförmigen, zur Achse X-X des Lüfters 4 grundsätzlich senkrecht verlaufenden Schutzgitterstruktur 8 vollständig abgedeckt wird. Am Rand der Ausströmöffnung 7 schließt sich ein rohrförmiger Gehäuserandansatz 9 an, der die seitliche Wand des Motorhalterungsteils 2 bildet und parallel zur Achse X-X des Lüfters 4 in Richtung des Lufteinlassteils 3 nach innen verläuft. Dabei entspricht der Durchmesser der Ausströmöffnung 7 dem Durchmesser des Gehäuserandansatzes 9.

Die Schutzgitterstruktur 8 wird aus mehreren, an Kreuzungspunkten miteinander verbundenen, ringförmig umlaufenden Schutzstreben 10 und radial verlaufenden Haltestreben 11 gebildet, wobei beide Strebenarten sowohl eine Halte- als auch eine Schutzfunktion haben und strömungsoptimiert ausgebildet sind. Im radial äußeren Bereich der Schutzgitterstruktur 8 wird die Tellerform durch nach außen gerichtete, schräg zur Achse X-X geneigte Haltestreben 11 gebildet, um in Abströmrichtung des, insbesondere durch ein Diagonallüfterrad erzeugten, Luftstroms einen minimalen Widerstand zu bieten. In der Schutzgitterstruktur 8 ist, vorzugsweise mittig, eine Motoraufnahme 14 mit Befestigungsmitteln, insbesondere Durchgangslöchern, zum Befestigen des Lüfters 4 vorgesehen.

Zusätzlich sind an dem äußeren Rand der Ausstromöffnung 7 ein umlaufender Befestigungsflansch 12 oder mindestens zwei abstehende Befestigungsflansche 12 angebracht, die senkrecht zum Gehäuserandansatz 9, über dem Umfang gleichmäßig verteilt, verlaufen. Zur Stärkung der Befestigungsflansche 12 sind auf der inneren, dem Lufteinlassteil 3 zugewandten Seite, senkrecht zu den Befestigungsflanschen 12 und tangential zu dem Gehäuserandansatz 9 verlaufende Stützansätze 13 angebracht, die die Befestigungsflansche 12 mit dem Gehäuserandansatz 9 zusätzlich verbinden und abstützen.

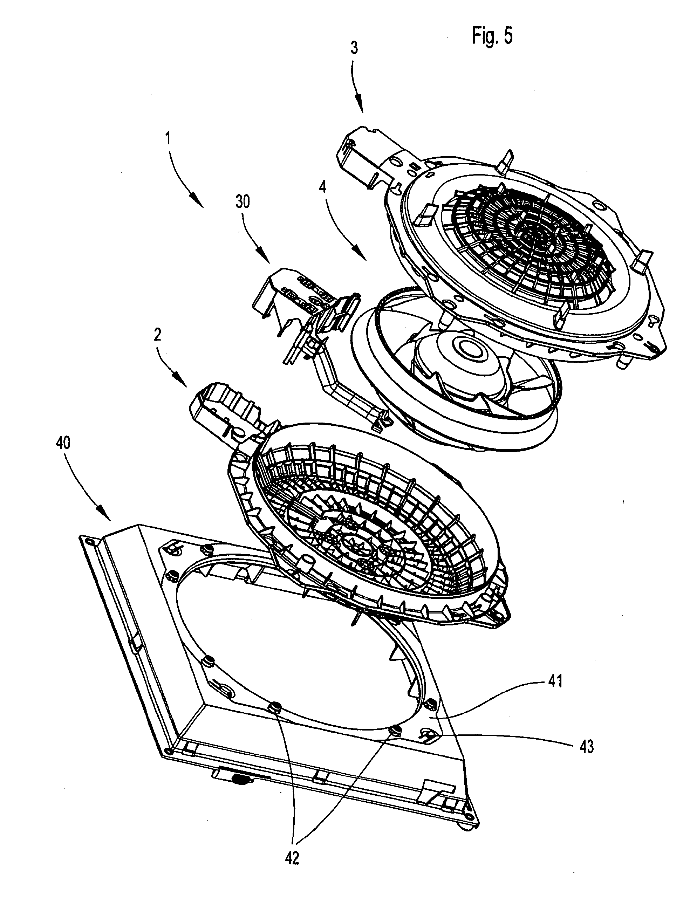

Die Befestigungsflansche 12 sind mit Befestigungsmitteln, insbesondere Befestigungsmitteln für einen Bajonettverschluss oder Durchgangslöcher zum Anschrauben, versehen, die zum Befestigen, insbesondere zum werkzeuglosen Befestigen, der Lüftereinheit 1 an einem in Fig. 5 dargestellten Filterrahmen 40 dienen. Die Befestigungsmittel können insbesondere aus mindestens einer schlüssellochförmigen Bajonett-Öffnung 15 bestehen. Zusätzlich kann mindestens ein Rastloch 16 und vorzugsweise ein, in dem Rastloch 16 angebrachter, einseitig mit dem Befestigungsflansch 12 verbundener Entriegelungsknopf 17 angeordnet sein.

Außerdem weist das Motorhalterungsteil 2 an einer Seite ein an dem Gehäuserandansatz 9 oder alternativ an dem Befestigungsflansch 12 angebrachtes, offenes Steckergehäuseteil 18 zur Aufnahme eines nicht dargestellten Steckeranschlusses der Lüftereinheit 1 und optional eines nicht dargestellten Kondensators auf. Zusätzlich verläuft von der Motoraufnahme 14 in der Innenseite der Schutzgitterstruktur 8 radial ein U-förmiger Kanal 19 zu dem Steckergehäuseteil 18, der zur Aufnahme einer nicht dargestellten Anschlussleitung des Lüfters 4 dient.

Das Lufteinlassteil 3 ist vorzugsweise einteilig ausgebildet und besteht vorzugsweise aus Kunststoff. Es weist eine Einlassöffnung 20 auf, die von einem ringförmigen geschlossenen Düsenabschnitt 29 umrandet wird. Die Einlassöffnung 20 verengt sich nach innen in das Gehäuse hinein und wird von einer integrierten, tellerförmigen, zur Achse X-X des Lüfters 4 grundsätzlich senkrecht verlaufenden Schutzgitterstruktur 21 vollständig abgedeckt. Am Rand des Düsenabschnitts 29 schließt sich ein rohrförmiger Gehäuserandansatz 22 an, der die seitliche Wand des Lufteinlassteils 3 bildet und parallel zur Achse X-X des Lüfters 4 nach innen in Richtung des Motorhalterungsteils 2 verläuft. Durch den geschlossenen Düsenabschnitt 29 ist der Durchmesser der Einlassöffnung 20 kleiner als der Durchmesser des Gehäuserandansatzes 22.

Alternativ kann auch das Motorhalterungsteil 2 einen in Richtung der Achse X-X breiteren Gehäuserandansatz 9 aufweisen, so dass auf den Gehäuserandansatz 22 des Lufteinlassteils 3 verzichtet werden kann, oder umgekehrt das Lufteinlassteil 3 einen in Richtung der Achse X-X breiteren Gehäuserandansatz 22 aufweisen, so dass auf den Gehäuserandansatz 9 des Motorhalterungsteils 2 verzichtet werden kann.

Die Schutzgitterstruktur 21 des Lufteinlassteils 3 wird aus mehreren, an Kreuzungspunkten miteinander verbundenen, ringförmig umlaufenden Schutzstreben 23 und radial verlaufenden Haltestreben 24 gebildet, wobei beide Strebenarten sowohl eine Halte- als auch eine Schutzfunktion haben und strömungsoptimiert ausgebildet sind. Im radial äußeren Bereich der Schutzgitterstruktur 21 wird die Tellerform durch nach außen gerichtete, schräg zur Achse X-X geneigte Haltestreben 24 gebildet, um in Einströmrichtung des, insbesondere durch ein Diagonallüfterrad erzeugten, Luftstroms einen minimalen Widerstand zu bieten.

Zusätzlich sind an dem äußeren Rand des Düsenabschnitts 29 ein umlaufender Befestigungsflansch 25 oder mindestens zwei abstehende Befestigungsflansche 25 angebracht, die senkrecht zum Gehäuserandansatz 22, über dem Umfang verteilt, verlaufen. Zur Stärkung der Befestigungsflansche 25 sind auf der inneren, dem Motorhalterungsteil 2 zugewandten Seite, senkrecht zu den Befestigungsflanschen 25 und tangential zu dem Gehäuserandansatz 22 verlaufende Stützansätze 13 angebracht, die die Befestigungsflansche 25 mit dem Gehäuserandansatz 22 zusätzlich verbinden und abstützen.

Die Befestigungsflansche 25 sind mit Befestigungsmitteln, insbesondere Befestigungsmitteln für einen Bajonettverschluss oder Durchgangslöcher zum Anschrauben, versehen, die zum Befestigen, insbesondere zum werkzeuglosen Befestigen, der Lüftereinheit 1 an einem in Fig. 5 dargestellten Filterrahmen 40 dienen. Die Befestigungsmittel können ebenfalls insbesondere aus mindestens einer schlüssellochförmigen Bajonett-Öffnung 15 bestehen. Zusätzlich kann mindestens ein Rastloch 16 und vorzugsweise ein, in dem Rastloch 16 angebrachter einseitig mit dem Befestigungsflansch 25 verbundener Entriegelungsknopf 17 angeordnet sein.

Außerdem weist das Lufteinlassteil 3 an einer Seite ein, an dem Gehäuserandansatz 22 oder alternativ an einem der Befestigungsflansche 25 angebrachtes, offenes Steckergehäuseteil 26 zur Aufnahme eines nicht dargestellten Steckeranschlusses der Lüftereinheit 1 und optional eines nicht dargestellten Kondensators auf.

Das Motorhalterungsteil 2 und das Lufteinlassteil 3 weisen an ihren Rändern über den Umfang verteilte Befestigungsmittel, vorzugsweise domförmige Schraubansätze 27 mit Gewindebohrungen und/oder Durchgangslöchern, zum Verbinden der beiden Teile miteinander auf. Auch eine Rastverbindung der beiden Teile ist möglich.

Auf der Außenseite des Düsenabschnitts 29 und auf der Außenfläche der Haltestreben und/oder Schutzstreben der Schutzgitterstruktur 21 des Lufteinlassteils 3 sind domförmige Abstandshalter 28 aufgebracht, die als Anlagepunkte für einen, vor der Einlassöffnung 20 montierten, nicht dargestellten Filter dienen und dadurch eine ausreichende Luftzufuhr für die Lüftereinheit 1 sicherstellen.

In der gezeigten Ausführungsform ist zusätzlich ein Steckeraufnahmeteil 30 in dem Gehäuse der Lüftereinheit 1 untergebracht. Das Steckeraufnahmeteil 30 weist Taschen 31 auf, die mit Federzungen 32 versehen sind, um so Toleranzen der Kondensatoren auszugleichen. Seitlich an dem Steckeraufnahmeteil 30 sind zwei Flanschflächen 33 vorgesehen, um nicht dargestellte Steckverbinder aufzunehmen. Zusätzlich weist das Steckeraufnahmeteil 30 einen U-förmigen Kanalansatz 34 auf, der im eingebauten Zustand des Steckeraufnahmeteils 30 den U-förmigen Kanal 19 des Motorhalterungsteils 2 abdeckt und somit einen Tunnel bildet, in dem die Anschlussleitung des Lüfters 4 aufgenommen wird und damit ein Streifen der Anschlussleitung an dem Lüfterrad 6 verhindert wird. Das Steckeraufnahmeteil 30 wird mittels Befestigungsmitteln, insbesondere Rastverbindungen, mit dem Motorhalterungsteil 2 verbunden. Zum Halten der Flanschflächen 33, welche die Steckverbinder aufnehmen, werden die Flanschflächen 33 hinter einem umlaufenden Rand des Motorhalterungsteils 2 und des Lufteinlassteils 3 formschlüssig fixiert.

Die Befestigungsflansche 12 des Motorhalterungsteils 2 und deren Befestigungsmittel 15,16,17 sowie die Befestigungsflansche 25 des Lufteinlassteils 3 und deren Befestigungsmittel 15, 16, 17 sind gleich ausgebildet, so dass die Lüftereinheit 1 durch eine 180° Drehung um eine zentrale zur Achse X-X des Lüfters 4 senkrechte Achse entweder als eine saugende oder eine blasende Lüftereinheit 1 an den Filterrahmen 40, insbesondere werkzeuglos und ohne Lösen eines Schutzgitters, befestigt werden kann.

In Fig. 5 wird zusätzlich zur erfindungsgemäßen Lüftereinheit 1 ein Filterrahmen 40 mit erfindungsgemäßen Befestigungsmitteln dargestellt. Die Befestigungsmittel sind auf mindestens zwei Befestigungsansätzen 41 des Filterrahmens 40 aufgebracht und bestehen insbesondere aus jeweils einem auf den Befestigungsansätzen 41 aufgebrachten, pilzförmigen Befestigungsknopf 42 und vorzugsweise mindestens einem Rasthaken 43. Dabei sind die Befestigungsknöpfe 42 so angeordnet, dass sie als Bajonettverschluss zusammen mit den schlüssellochförmigen Bajonett-Öffnungen 15 der Befestigungsmittel der Lüftereinheit 1 zusammenwirken. Die Befestigung der Lüftereinheit 1 an dem Filterrahmen 40 wird vorzugsweise mittels des Rasthakens 43, der im befestigten Zustand in das Rastloch 16 des Befestigungsflansches 12 bzw. 25 der Lüftereinheit 1 einrastet, gegen Lösen gesichert. Der Rasthaken 43 kann mittels der Entriegelungsknöpfe 16 der Befestigungsflansche 12 bzw. 25 der Lüftereinheit 1 aus dem Rastloch 16 gedrückt und somit gelöst werden.

Die Befestigungflansche 12 bzw. 25 des Motorhalterungsteils 2 bzw. des Lufteintassteils 3 und deren Befestigungsmittel 15, 16, 17, und die Befestigungsmittel 42, 43 des Filterrahmens 40 sind insbesondere so angeordnet, dass eine Befestigung der Befestigungsflansche 12 bzw. 25 an den jeweils gegenüberliegenden Befestigungsansätzen 41 des Filterrahmens 40 mit einem Drehwinkel der Lüftereinheit 1 um die Achse X-X des Lüfters 4 von jeweils 90° möglich ist. Dies ermöglicht, dass das aus den beiden Steckergehäuseteilen 18 und 26 gebildete Steckergehäuse in vier verschiedene Positionen eingestellt werden kann, um die Lüftereinheit 1 an die jeweiligen Raumbedingungen der Umgebung und des Filterlüfters anzupassen.

## Patentansprüche

1. Lüftereinheit (1) zur Befestigung an einem Filterrahmen (40) eines Filterlüfters, bestehend aus einem Gehäuse mit einem zylinderförmigen Gehäuserand, einer Einlassöffnung (20) mit einem Schutzgitter, welches die Einlassöffnung (20) abdeckt, einer Ausströmöffnung (7) mit einem Schutzgitter, welches die Ausströmöffnung (7) abdeckt, und einem in dem Gehäuse durch eine Motoraufnahme (14) befestigten Lüfter (4), wobei der
Lüfter (4) einen Elektromotor mit einem auf dem Rotor des Elektromotors befestigten Diagonallüfterrad oder Axiallüfterrad als Lüfterrad (6) aufweist, und wobei das Gehäuse senkrecht zur Achse (X-X) des Lüfters (4) im Bereich des Gehäuserandes (9, 22) in mindestens zwei lösbar miteinander verbundene Gehäuseteile geteilt ist, wobei das eine Gehäuseteil mit der Ausströmöffnung (7) und das andere Gehäuseteil als ein Lufteinlassteil (3) mit der Einlassöffnung (20) ausgebildet ist,
**dadurch gekennzeichnet, dass** das mit der Ausströmöffnung (7) versehene Gehäuseteil als ein Motorhalterungsteil (2) ausgebildet ist, wobei sowohl das Motorhalterungsteil (2) als auch das L.ufteinlassteil (3) jeweils einstückig eine Schutzgitterstruktur (8, 21) bilden, und wobei die Schutzgitterstruktur (8) des Motorhalterungsteils (2) eine Motoraufnahme (14) mit Befestigungsmitteln zur Befestigung des Lüfters (4) aufweist, und das Motorhalterungsteil (2) und das Lufteinlassteil (3) jeweils an ihrem Umfang gleich ausgebildete Befestigungsflansche (12, 25) mit gleich ausgebildeten Befestigungsmitteln (15, 16, 17) aufweisen, so dass die Lüftereinheit durch eine 180 ° Drehung um eine zentrale zur Achse X-X des Lüfters (4) senkrechte Achse an dem Filterrahmen (40) befestigbar ist.

2. Lüftereinheit (1) nach Anspruch 1,
**dadurch gekennzeichnet, dass** das Motorhalterungsteil (2) und/oder das Lufteinlassteil (3) einstückig einen am Umfang der Schutzgitterstruktur (8 bzw. 21) angebrachten, zur Achse (X-X) des Lüfters (4) parallel in Richtung des Lufteinlassteils (3) bzw. des Motorhalterungsteils (2) verlaufenden zylinderförmigen Gehäuserandansatz (9, 22) aufweist.

3. Lüftereinheit (1) nach Anspruch 1 oder 2,
**dadurch gekennzeichnet, dass** das Lufteinfassteil (3) auf der Außenseite eines Düsenabschnitts (29) und auf einer Außenfläche der Schutzstreben und/oder Haltestreben der Schutzgitterstruktur (21) domförmige Abstandshalter (28) aufweist.

4. Lüftereinheit (1) nach einem der Ansprüche 1 bis 3,
**dadurch gekennzeichnet, dass** das Gehäuse im Bereich des zylinderförmigen Gehäuserandes mittig geteilt ist.

5. Lüftereinheit (1) nach einem der Ansprüche 1 bis 4,
**dadurch gekennzeichnet, dass** die Befestigungsmittel (15, 16, 17) der Befestigungsflansche (12, 25) der Lüftereinheit zusammen mit Befestigungsmitteln (42, 43) des Filterrahmens (40) einen Bajonettverschluss bilden.

6. Lüftereinheit (1) nach einem der Ansprüche 1 bis 5,
**dadurch gekennzeichnet, dass** die Befestigungsmittel (15, 16, 17) der Befestigungsflansche (12, 25) aus mindestens einer schlüssellochförmigen Bajonett-Öffnung (15) bestehen.

7. Lüftereinheit (1) nach einem der Ansprüche 1 bis 6,
**dadurch gekennzeichnet, dass** sowohl das Motorhalterungsteil (2) als auch das Lufteinlassteil (3) vier im Winkel von 90° über den Umfang gleichmäßig verteilte Befestigungsflansche (12, 25) aufweisen.

8. Lüftereinheit (1) nach einem der Ansprüche 1 bis 7,
**dadurch gekennzeichnet, dass** die Befestigungsmittel (15, 16, 17) der Befestigungsflansche (12, 25) ein Rastloch (16) mit einem in dem Rastloch (16), über einen radialen Steg angebrachten Entriegelungsknopf (17) aufweisen.

9. Lüftereinheit (1) nach einem der Ansprüche 1 bis 8,
**dadurch gekennzeichnet, dass** im radial äußeren Bereich der einen oder beiden Schutzgitterstruktur(en) (8, 21) nach außen gerichtete, schräg zur Achse (X-X) des Lüfters geneigte Haltestreben (10, 24) ausgebildet sind, so dass eine oder beide Schutzgitterstruktur(en) (8, 21) tellerförmig ausgebildet ist/sind, und der Tellerboden nach außen aus der jeweiligen durch die Schutzgitterstruktur (8, 21) abgedeckten Öffnung (7, 20) der Gehäuseteile (2, 3) herausragt.

10. Lüftereinheit (1) nach einem der Ansprüche 2 bis 9,
**dadurch gekennzeichnet, dass** das Motorhalterungsteil (2) und das Lufteinlassteil (3) jeweils seitlich am Umfang des Gehäuserandansatzes (9, 22) oder alternativ an dem Befestigungsflansch (12, 25) ein offenes Steckergehäuseteil (18, 26) zur Aufnahme eines Steckeranschlusses der Lüftereinheit (1) aufweist.

11. Lüftereinhelt (1) nach Anspruch 10,
**dadurch gekennzeichnet, dass** innerhalb des aus den Steckergehäuseteilen (18, 26) gebildeten Steckergehäuses eine Steckeraufnahmeteil (30) angeordnet ist.

12. Lüftereinheit (1) nach einem der Ansprüche 2 bis 11,
**dadurch gekennzeichnet, dass** der Durchmesser der Ausströmöffnung (7) dem Durchmesser des Gehäuserandansatzes (9) des Motorhalterungsteils (2) entspricht, und der Durchmesser der Einlassöffnung (20) kleiner als der Durchmesser des Gehäuserandansatzes (22) des Lufteinlassteils (3) ist.

## Claims

1. A fan unit (1) for fastening to a filter frame (40) of a filter fan, consisting of a housing with a cylindrical housing edge, an inlet opening (20) with a protective grille which covers the inlet opening (20), an outflow opening (7) with a protective grille which covers the outflow opening (7), and a fan (4) fastened in the housing by a motor mount (14), the fan (4) having an electric motor with a diagonal fan impeller or axial fan impeller, fastened to the rotor of the electric motor, as fan impeller (6), and the housing being divided, perpendicular to the axis (X-X) of the fan (4) in the region of the housing edge (9, 22), into at least two housing parts which are detachably connected together, the one housing part being formed with the outflow opening (7) and the other housing part being formed as an air inlet part (3) with the inlet opening (20),
**characterised in that** the housing part provided with the outflow opening (7) is formed as a motor-holder part (2), with both the motor-holder part (2) and the air inlet part (3) in each case forming in one piece a protective grille structure (8, 21), and the protective grille structure (8) of the motor-holder part (2) having a motor mount (14) with fastening means for fastening the fan (4), and the motor-holder part (2) and the air inlet part (3) having in each case on their periphery identically-formed fastening flanges (12, 25) with identically-formed fastening means (15, 16, 17), so that the fan unit can be fastened to the filter frame (40) by rotating by 180° about a central axis perpendicular to the axis X-X of the fan (4).

2. A fan unit (1) according to Claim 1, **characterised in that** the motor-holder part (2) and/or the air inlet part (3) have in one piece a cylindrical housing-edge projection (9, 22) attached to the periphery of the protective grille structure (8 or 21 respectively) and extending parallel to the axis (X-X) of the fan (4) in the direction of the air inlet part (3) or of the motor-holder part (2).

3. A fan unit (1) according to Claim 1 or 2, **characterised in that** the air inlet part (3) has dome-shaped spacers (28) on the outside of a nozzle section (29) and on an outer surface of the protective struts and/or holding struts of the protective grille structure (21).

4. A fan unit (1) according to one of Claims 1 to 3, **characterised in that** the housing is divided centrally in the region of the cylindrical housing edge.

5. A fan unit (1) according to one of Claims 1 to 4, **characterised in that** the fastening means (15, 16, 17) of the fastening flanges (12, 25) of the fan unit together with fastening means (42, 43) of the filter frame (40) form a bayonet lock.

6. A fan unit (1) according to one of Claims 1 to 5, **characterised in that** the fastening means (15, 16, 17) of the fastening flanges (12, 25) consist of at least one keyhole-shaped bayonet opening (15).

7. A fan unit (1) according to one of Claims 1 to 6, **characterised in that** both the motor-holder part (2) and the air inlet part (3) have four fastening flanges (12, 25) uniformly distributed over the periphery at angles of 90°.

8. A fan unit (1) according to one of Claims 1 to 7, **characterised in that** the fastening means (15, 16, 17) of the fastening flanges (12, 25) have a latching hole (16) with an unlocking knob (17) which is attached in the latching hole (16) via a radial bar.

9. A fan unit (1) according to one of Claims 1 to 8, **characterised in that** outwards-directed holding struts (10, 24) which are inclined obliquely to the axis (X-X) of the fan are formed in the radially outer region of one or both protective grille structure(s) (8, 21), so that one or both protective grille structure(s) (8, 21) is/are formed in a plate shape, and the base of the plate protrudes outwards out of the respective opening (7, 20) of the housing parts (2, 3) which is covered by the protective grille structure (8, 21).

10. A fan unit (1) according to one of Claims 2 to 9, **characterised in that** the motor-holder part (2) and the air inlet part (3) have in each case laterally on the periphery of the housing-edge projection (9, 22) or alternatively on the fastening flange (12, 25) an open plug housing part (18, 26) for receiving a plug connection of the fan unit (1).

11. A fan unit (1) according to Claim 10, **characterised in that** a plug-receiving part (30) is arranged within the plug housing formed of the plug housing parts (18, 26).

12. A fan unit (1) according to one of Claims 2 to 11, **characterised in that** the diameter of the outflow opening (7) corresponds to the diameter of the housing-edge projection (9) of the motor-holder part (2), and the diameter of the inlet opening (20) is smaller than the diameter of the housing-edge projection (22) of the air inlet part (3).

## Revendications

1. Unité de ventilateur (1) pour la fixation sur un cadre de filtre (40) d'un ventilateur à filtre, se composant d'un boîtier avec un bord de boîtier cylindrique, d'une ouverture d'entrée (20) avec une grille de protection qui recouvre l'ouverture d'entrée (20), d'une ouverture de sortie (7) avec une grille de protection qui recouvre l'ouverture de sortie (7), et d'un ventilateur (4) fixé dans le boîtier par un logement de moteur (14), dans lequel le ventilateur (4) présente un moteur électrique avec une roue de ventilateur diagonale ou une roue de ventilateur axiale fixée sur le rotor du moteur électrique en guise de roue de ventilateur (6), et dans lequel le boîtier est divisé perpendiculairement à l'axe (X-X) du ventilateur (4) dans la zone du bord de boîtier (9, 22) en au moins deux parties de boîtier reliées de manière détachable l'une à l'autre, une partie de boîtier étant réalisée avec l'ouverture de sortie (7) et l'autre partie de boîtier comme une partie d'entrée d'air (3) avec l'ouverture d'entrée (20),
**caractérisée en ce que** la partie de boîtier pourvue de l'ouverture de sortie (7) est réalisée comme une partie de support de moteur (2), dans lequel non seulement la partie de support de moteur (2) mais aussi la partie d'entrée d'air (3) forment respectivement d'un seul tenant une structure de grille de protection (8, 21), et dans lequel la structure de grille de protection (8) de la partie de support de moteur (2) présente un logement de moteur (14) avec des moyens de fixation pour la fixation du ventilateur (4), et la partie de support de moteur (2) et la partie d'entrée d'air (3) présentent respectivement des brides de fixation (12, 25) réalisées de manière identique sur leur périphérie avec des moyens de fixation (15, 16, 17) réalisés de manière identique de sorte que l'unité de ventilateur puisse être fixée par une rotation de 180° autour d'un axe central perpendiculaire à l'axe X-X du ventilateur (4) sur le cadre de filtre (40).

2. Unité de ventilateur (1) selon la revendication 1,
**caractérisée en ce que** la partie de support de moteur (2) et/ou la partie d'entrée d'air (3) présente d'un seul tenant une saillie d'extrémité de boîtier (9, 22) cylindrique s'étendant parallèlement à l'axe (X-X) du ventilateur (4) en direction de la partie d'entrée d'air (3) ou de la partie de support de moteur (2), montée sur la périphérie de la structure de grille de protection (8 ou 21).

3. Unité de ventilateur (1) selon la revendication 1 ou 2,
**caractérisée en ce que** la partie d'entrée d'air (3) présente des éléments d'écartement en forme d'épine (28) sur le côté extérieur d'une section de buse (29) et sur une surface extérieure des entretoises de protection et/ou des entretoises de retenue de la structure de grille de protection (21).

4. Unité de ventilateur (1) selon l'une quelconque des revendications 1 à 3,
**caractérisée en ce que** le boîtier est divisé au milieu dans la zone du bord de boîtier cylindrique.

5. Unité de ventilateur (1) selon l'une quelconque des revendications 1 à 4,
**caractérisée en ce que** les moyens de fixation (15, 16, 17) des brides de fixation (12, 25) de l'unité de filtre forment une fermeture à baïonnette conjointement avec des moyens de fixation (42, 43) du cadre de filtre (40).

6. Unité de ventilateur (1) selon l'une quelconque des revendications 1 à 5,
**caractérisée en ce que** les moyens de fixation (15, 16, 17) des brides de fixation (12, 25) se composent d'au moins une ouverture à baïonnette (15) en forme de trou de serrure.

7. Unité de ventilateur (1) selon l'une quelconque des revendications 1 à 6,
**caractérisée en ce que** non seulement la partie de support de moteur (2) mais aussi la partie d'entrée d'air (3) présentent quatre brides de fixation (12, 25) réparties régulièrement en angle de 90° sur la périphérie.

8. Unité de ventilateur (1) selon l'une quelconque des revendications 1 à 7,
**caractérisée en ce que** les moyens de fixation (15, 16, 17) des brides de fixation (12, 25) présentent un trou d'encliquetage (16) avec un bouton de déverrouillage (17) monté dans le trou d'encliquetage (16) sur une nervure radiale.

9. Unité de ventilateur (1) selon l'une quelconque des revendications 1 à 8,
**caractérisée en ce que** des entretoises de retenue (10, 24) dirigées vers l'extérieur, inclinées en biais par rapport à l'axe (X-X) du ventilateur sont réalisées dans la zone radiale extérieure de l'une ou des deux structures de grille de protection (8, 21) de sorte que l'une ou les deux structures de grille de protection (8, 21) soient réalisées en forme de disque et le fond du disque dépasse vers l'extérieur de l'ouverture (7, 20) respective recouverte par la structure de grille de protection (8, 21) des parties de boîtier (2, 3).

10. Unité de ventilateur (1) selon l'une quelconque des revendications 2 à 9,
**caractérisée en ce que** la partie de support de moteur (2) et la partie d'entrée d'air (3) présentent respectivement latéralement, sur la périphérie de la saillie d'extrémité de boîtier (9, 22), ou en variante sur la bride de fixation (12, 25), une partie de boîtier de connexion (18, 26) ouverte pour le logement d'un raccordement de connexion de l'unité de ventilateur (1).

11. Unité de ventilateur (1) selon la revendication 10,
**caractérisée en ce qu'**une partie de logement de connexion (30) est disposée dans le boîtier de connexion formé des parties de boîtier de connexion (18, 26).

12. Unité de ventilateur (1) selon l'une quelconque des revendications 2 à 11,
**caractérisée en ce que** le diamètre de l'ouverture de sortie (7) correspond au diamètre de la saillie d'extrémité de boîtier (9) de la partie de support de moteur (2) et le diamètre de l'ouverture d'entrée (20) est inférieur au diamètre de la saillie d'extrémité de boîtier (22) de la partie d'entrée d'air (3).
